# EUROPEAN PATENT SPECIFICATION

(11) **EP 1 813 406 B1**
(45) Date of publication and mention of the grant of the patent: **22.06.2011**
(21) Application number: 07001647.2
(22) Date of filing: 25.01.2007
(51) Int. Cl.: B29C 33/72

(54) **Sheet for regenerating a mold**
Folie zur Regenerierung eines Formwerkzeuges
Feuille pour la régénération d'un moule

(30) Priority: 27.01.2006 JP 2006019638; 27.01.2006 JP 2006019639; 23.10.2006 JP 2006287717
(43) Date of publication of application: 01.08.2007
(73) Proprietor: NITTO DENKO CORPORATION, Ibaraki-shi, Osaka 567-8680 (JP)
(72) Inventor: Takashima, Kouichi c/o Nitto Electr. Kyushu Corp., Kanzaki Saga 842-0031 (JP)
(74) Representative: Kuhnen & Wacker

(56) References cited:
- EP-A1- 0 342 163
- EP-A2- 0 271 107
- JP-A- 7 304 044

## Description

### BACKGROUND OF THE INVENTION

### 1. Field of the Invention

The present invention relates to a sheet for regenerating a mold to be used for cleaning a surface of the mold.

### 2. Description of the Related Art

In a step of resin molding a semiconductor device through transfer molding, resin molding by using a mold is generally continuously conducted. With increased repeating number (shot number) of the resin molding, contamination such as components effused from the resin, burr, and dust accumulates on a surface of the mold, in particular, on a cavity surface. Such contamination degrades releasability for taking out a molded product from the mold and forms a rough surface on the molded product and the like. Thus, the surface of the mold (cavity surface) is cleaned for every certain repeating number (shot number) of molding.

EP 0 271 107 A2 discloses a mold-cleaning sheet comprising a fibrous base material sheet and an uncured rubber composition wherein the top part of the uncured rubber composition has a flat top part with cutting marks formed by simple cut or printing of definite intervals for cutting the sheet into pieces of definite size. No air vent gaps are present in the flat pattern on top part of the uncured rubber composition layer.

JP 07-304044 A discloses a method for cleaning a mold with complicated details employing a sheet-form substrate with a plurality of cleaning resin blocks which are disposed on the substrate in accordance with the position of a mold cavity to be formed integrally with the substrate. Accordingly, the particular cleaning resin blocks are shaped to match exactly to the size of mold cavities. No air vent gaps on the top layer of the particular cleaning blocks are present.

There is proposed a cleaning method by using a cleaning sheet (see JP 2004-130819 A, for example). This method involves: mold clamping the cleaning sheet sandwiched between an upper mold and a lower mold for filling the cleaning sheet into a cavity; heat molding the whole in such a state for attaching the contamination to the cleaning sheet; and releasing the cleaning sheet for removing the contamination together with the cleaning sheet from the surface of the mold (cavity surface).

However, in use of the cleaning sheet, air in the cavity may be hardly be vented depending on a shape of the cavity. Such a case has a problem in that the cleaning sheet is not filled in an air accumulated part and the contamination is not removed.

Thus, the inventors of the present invention have conducted studies on reasons for air accumulation. As a result, the inventors of the present invention have found out that the reason is because the cleaning sheet has a uniform flat surface. That is, in the case where the cleaning sheet has a uniform flat surface, the cleaning sheet blocks an entire opening of the cavity when the cleaning sheet is sandwiched between the upper mold and the lower mold, and air in the cavity cannot be vented even under mold clamping in such a state.

In the case where the cleaning sheet is formed of a cleaning material such as unvulcanized rubber alone and where the cleaning sheet (cleaning material alone) is sandwiched between the upper mold and the lower mold, a shorter distance between the molds reduces the strength of the cleaning material and the cleaning material is hardly removed from the molds after the cleaning. For preventing such a phenomenon, the mold clamping is conducted with a longer distance between the molds, and thus a large amount of the cleaning material is required. Further, a longer distance between the molds inhibits application of sufficient compressive force on the cleaning material. Thus, air in the cavity cannot be dissolved or diffused in the cleaning material, or the cleaning material cannot be filled into the entire cavity.

### SUMMARY OF THE INVENTION

The present invention has been made from a viewpoint of the circumstances described above, and an obj ect of the present invention is therefore to provide a sheet for regenerating a mold capable of easily venting air in a cavity and exhibiting excellent filling property.

In order to attain the above-mentioned object, a sheet for regenerating a mold according to the present invention includes: a substrate sheet formed of one of a paper sheet, a cloth sheet, and a plastic sheet; and a mold cleaning material containing as a main component an unvulcanized rubber-based composition, projecting in a predetermined pattern having an air vent gap, and formed on at least one side of the substrate sheet.

The inventors of the present invention have further conducted studies based on the above-mentioned result of investigation on air accumulation. As a result, the inventors of the present invention have found out that in the case where a surface of a mold (cavity surface) is cleaned by using a sheet for regenerating a mold including: a substrate sheet formed of one of a paper sheet, a cloth sheet, and a plastic sheet; and a mold cleaning material containing as a main component an unvulcanized rubber-based composition, projecting in a predetermined pattern having an air vent gap, and formed on at least one side of the substrate sheet, the mold cleaning material is filled into the cavity while a contact surface between the projected mold cleaning material and the surface of the mold (cavity surface) gradually expands. During this time, air in the cavity is vented, and the mold cleaning material spreads throughout the cavity to clean the entire cavity. In this way, the inventors have attained the present invention.

That is, in the case where the sheet for regenerating a mold of the present invention is sandwiched between the upper mold and the lower mold, a projected part of the mold cleaning material blocks a part of an opening of the cavity and other parts of the opening are not blocked by the projected part and remain opened. During mold clamping in such a state, the mold cleaning material is filled into the cavity from the part of the opening of the cavity while a contact surface with the surface of the mold (cavity surface) gradually expands, and air in the cavity is discharged from the other parts of the opening not blocked by the projected part. In this way, no air accumulates in the cavity, and the mold cleaning material is filled throughout the cavity. During heat molding in suchastate, the mold cleaningmaterial containing as amain component an unvulcanized rubber-based composition is vulcanized, and contamination on the surface of the mold (cavity surface) attaches to the vulcanized rubber. As a result, cleaning can be conducted throughout the cavity.

The sheet for regenerating a mold of the present invention includes: a substrate sheet formed of one of a paper sheet, a cloth sheet, and a plastic sheet; and a mold cleaning material containing as a main component an unvulcanized rubber-based composition, projecting in a predetermined pattern having an air vent gap, and formed on at least one side of the substrate sheet. Thus, in the case where the mold is cleaned by using the sheet for regenerating a mold of the present invention, the opening of the cavity can be partly blocked by the projected part of the mold cleaning material, and air in the cavity can be vented while the mold cleaning material is filled. In this way, filling property of the mold cleaning material improves, and cleaning can be conducted throughout the cavity.

Further, the substrate sheet is provided for application of sufficient pressure on the mold cleaning material during mold clamping, and thus air remained in a gap between the cavity and the sheet for regenerating a mold can be dissolved or diffused in the mold cleaning material. A conventional sheet for regenerating a mold formed of a mold cleaning material alone expands into a circle by mold clamping and involves troubles such as leaking of an excess mold cleaning material from an edge of the mold and insufficient cleaning of corners of the mold. A sheet for regenerating a mold of the present invention provided with the substrate sheet is capable of controlling flow of the mold cleaning material and cleaning corners of the mold, and thus the mold cleaning material does not leak from the edge of the mold. The mold cleaning material is reinforced by providing the substrate sheet. Thus, in the case where the sheet for regenerating a mold is taken out of the mold after cleaning, the mold cleaning material does not tear and does not remain attached to the mold. Reinforcement of the mold cleaning material by the substrate sheet allows mold clamping with a shorter distance between molds and requires a small amount of the mold cleaning material.

In the case where the pattern is formed as one of a plurality of belts, a lattice, and a plurality of dots, the shape and dimensions of the pattern and an air vent gap are easily set, and the mold cleaning material may be set into an appropriate pattern for filling into the cavity.

In particular, in the case where a width and a thickness of each of the belts, vertical lines of the lattice, horizontal lines thereof, and the dots are set within a range of 1 to 5 mm and a distance between adjacent belts, vertical lines of the lattice, horizontal lines thereof, and dots is set within a range of 1 to 5 mm, appropriate dimensions for cleaning a mold for transfer molding to be used for resin molding of a semiconductor device can be obtained, and the mold for transfer molding can appropriately be cleaned.

In the case where a top part of the pattern has a non-flat top part, air in the cavity can be vented while the mold cleaning material is filled thereinto even if an opening of the cavity is small, and cleaning can be conducted throughout the cavity.

In particular, in the case where the non-flat top part of the pattern is formed of a convex part having a curvature radius within a range of 0.2 to 3.0 mm, filling property of the mold cleaning material improves and cleaning property in the cavity further improves.

In the case where the cloth sheet is formed of a nonwoven fabric, a surface of the cloth sheet becomes a rough surface. Thus, an anchor effect of the mold cleaning material improves, and adhesion between the cloth sheet and the mold cleaning material enhances.

Of those, in the case where the nonwoven fabric is a spunbond nonwoven fabric, there is relatively no directional property in tensile strength and stress applied during heat molding is easily absorbed and relaxed. Thus, the sheet hardly tears during heat molding. Further, the sheet does not tear during peeling off (releasing) from the mold, to thereby facilitate a peeling (releasing) operation.

In the case_where the substrate sheet is subjected to an embossing treatment, a surface of the cloth sheet becomes a rough surface. Thus, an anchor effect of the mold cleaning material improves, and adhesion between the substrate sheet and the mold cleaning material enhances.

Further, in the case where the plastic sheet is one of a perforated sheet and a porous sheet, a surface of the plastic sheet becomes a rough surface. Thus, an anchor effect of the mold cleaning material improves, and adhesion between the plastic sheet and the mold cleaning material enhances.

### BRIEF DESCRIPTION OF THE DRAWINGS

In the accompanying drawings:
FIG. 1 is a perspective view showing a first embodiment of a sheet for regenerating a mold which does not form part of the present invention;
FIG. 2 is a schematic diagram showing a cleaning method by using the sheet for regenerating a mold from FIG. 1;
FIG. 3 is a schematic diagram showing the cleaning method by using a sheet for regenerating a mold which does not form part of the present invention;
FIG. 4 is a perspective view showing a second embodiment of the sheet for regenerating a mold which does not form part of the present invention;
FIG. 5 is a schematic diagram showing a method of using the sheet for regenerating a mold which does not form part of the present invention;
FIG. 6 is a perspective view showing a third embodiment of the sheet for regenerating a mold which does not form part of the present invention;
FIG. 7 is a perspective view showing a modified example of projected lines of the first embodiment;
FIG. 8 is a perspective view showing a modified example of projected lines of the second embodiment;
FIG. 9 is a perspective view showing a modified example of projected lines of the third embodiment;
FIGS. 10 (a) to 10 (f) are each a sectional view showing amodified example of the projected lines of the sheet for regenerating a mold of the present invention;
FIG. 11 is a perspective view showing a fourth embodiment of the sheet for regenerating a mold which does not form part of the present invention; and
FIG. 12 is a perspective view showing a modified example of dots of the fourth embodiment.

### DETAILED DESCRIPTION OF THE PREFERRED EMBODIMENTS

Next, embodiments of the present invention will be described more specifically based on drawings.

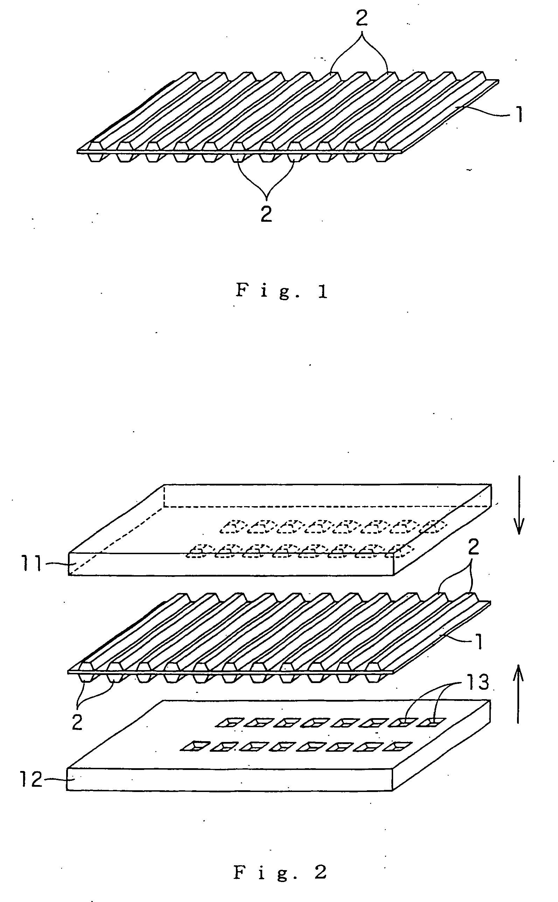

FIG. 1 shows a first embodiment of a sheet for regenerating a mold which does not form part of the present invention. The sheet for regenerating a mold according to this embodiment includes a plurality of projected lines (belts) formed of a mold cleaning material 2 containing as a main component an unvulcanized rubber-based composition on both sides of a substrate sheet 1. In this way, the mold cleaning material 2 is formed into a belt-like pattern. The projected lines as constitutional components of the belt-like pattern are arranged parallel to each other with a distance therebetween. In this embodiment, the projected lines are each formed to have a trapezoidal sectional shape.

To be more specific, the substrate sheet 1 serves as a basis for allowing the mold cleaning material 2 to project. As properties required for the substrate sheet 1, the substrate sheet 1 preferably withstands a flow pressure of the mold cleaning material 2 flowing into the cavity and preferably withstands a molding temperature (generally, 100 to 160°C). From a viewpoint of withstanding the flow pressure, the substrate sheet 1 preferably has a tear strength of 8 N or more. A tear strength of less than 8 N allows easy tear of the substrate sheet. However, in the case where the substrate 1 sheet is too hard, a guide pin or the like provided in the mold may be damaged, and thus appropriate hardness must be selected. The substrate sheet 1 providing strong adhesion (having grip property) with the mold cleaning material 2 is preferably selected such that the substrate sheet 1 and the vulcanized mold cleaning material 2 are integrated and taken out when the sheet for regenerating a mold is taken out of the mold after molding. The reason is because if the mold cleaning material 2 is peeled off from the substrate sheet 1, the mold cleaning material 2 remains in the mold (cavity) and is hardly removed.

Examples of the substrate sheet 1 include a paper sheet, a cloth sheet, and a plastic sheet. Of those, in the case where a paper sheet or a cloth sheet is used, a part of the mold cleaning material 2 provided on the surface of the substrate sheet 1 is embedded in the substrate sheet 1 and an anchor effect improves. Further, the substrate sheet 1 has relative flexibility and easily deforms (follows) an uneven shape of the surface of the mold, and thus the mold cleaning material 2 can be sufficiently adhered to the mold. Meanwhile, in the case where a plastic sheet is used, sufficient pressure for filling the mold cleaning material (having a belt-like shape) 2 throughout the cavity increases when the plastic sheet is sandwiched between the molds and pressured for cleaning the surface of the mold. Further, the'substrate sheet 1 hardly tears during heat molding or peeling off (releasing) from the molds.

Examples of the paper sheet include Japanese paper, foreign paper, synthetic paper, and mixed paper. Of those, Japanese paper has an appropriate rough surface and is capable of improving the anchor effect of the mold cleaning material 2 and enhancing adhesion with the mold cleaning material 2 (having grip property) . From this viewpoint, Japanese paper is preferred. The paper sheet to be used has a basis weight within a range of 20 to 250 g/m², and preferably 30 to 100 g/m².

Examples of the cloth sheet include a woven fabric, a nonwoven fabric, and a knitted fabric. Of those, a woven fabric and a nonwoven fabric containing long fibers each have an appropriate rough surface and are each capable of improving the anchor effect of the mold cleaning material 2 and enhancing adhesion with the mold cleaning material 2 (having grip property) . From this viewpoint, the woven fabric and the nonwoven fabric containing long fibers are preferred, and the nonwoven fabric is more preferred from a viewpoint of uniform grip property. Examples of a material for the long fiber include nylon, polyester, and polypropylene. Of those, polyester is preferred from a viewpoint of heat resistance. Further, as the nonwoven fabric, a spunbond nonwoven fabric is preferred from a viewpoint of mechanical strength, uniformity, and workability. The cloth sheet to be used has a thickness within a range of 0.1 to 0.8 mm, and preferably 0.2 to 0.4 mm, and a basis weight within a range of 20 to 250 g/m², and preferably 50 to 200 g/m².

Examples of a material used for forming the plastic sheet include: polyester such as polyethylene terephthalate or polyethylene naphthalate; polyimide; polyamide (nylon); and polypropylene. The plastic sheet to be used has a thickness within a range of 0.02 to 1 mm, and preferably 0.05 to 0.5 mm. Of those, from viewpoints of improving the anchor effect of the mold cleaning material 2 and enhancing adhesion with the mold cleaning material 2 (having grip property), a plastic sheet subjected to surface roughening treatment, a plastic sheet subjected to perforation treatment, a porous sheet, and the like are preferred. The porous sheet is formed of polypropylene, for example.

The dimensions of the belt-like pattern of parallel projected lines formed of the mold cleaning material 2 are arbitrarily set in accordance with the size, arrangement, and the like of the cavity of the mold and are not particularly limited. In particular, from a viewpoint of efficient air ventilation, as the dimensions for resin molding (transfer molding) a semiconductor device, the width and thickness of each of the projected lines are preferably set within a range of 1 to 5 mm, and the distance between the adjacent (opposing) projected lines is preferably set within a range of 1 to 5 mm.

A color of the mold cleaning material 2 is not particularly limited, but is preferably a pale color such as white color or gray color. The reason is that contamination to be removed from the cavity of the mold has a dark color such as black color. Thus, attachment of the contamination on the sheet for regenerating a mold can be visually confirmed after cleaning and a cleaning state can be easily confirmed. For a pale color, a white color-based pigment or the like is added to the unvulcanized rubber-based composition.

As described above, the mold cleaning material 2 contains as a main component an unvulcanized rubber-based composition, and a composition in the unvulcanized rubber-based composition differs depending on a content of cleaning shown in the following items (A) and (B). That is, the cleaning involves: (A) removing contamination on the surface of the mold (cavity surface) ; and (B) imparting releasability to the surface of the mold (cavity surface), after the completion of removing contamination from the surface of the mold (cavity surface).

First, a first example of the item (A), that is, themoldcleaning material 2 for removing contamination will be described. The first example includes as a mother material an unvulcanized rubbermaterial formed of a mixture of unvulcanized rubber and glycol ethers represented by the following general formula (1). 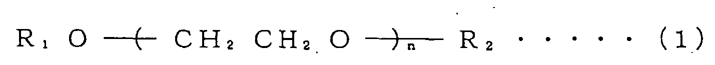 In the formula (1): n represents a positive integer; R₁ and R₂ each represent hydrogen or an alkyl group; when one of R₁ and R₂ represents hydrogen, the other represents an alkyl group; and when both R₁ and R₂ each represent an alkyl group, R₁ and R₂ may be identical to or different from each other.

Examples of the glycol ethers represented by the general formula (1) include ethylene glycol dimethyl ether, diethylene glycol dimethyl ether, triethylene glycol dimethyl ether, tetraethylene glycol dimethyl ether, polyethylene glycol dimethyl ether, diethylene glycol monomethyl ether, diethylene glycol monoethyl ether, diethylene glycol monopropyl ether, diethylene glycol monobutyl ether, diethylene glycol diethyl ether, diethylene glycol propyl ether, diethylene glycol dibutyl ether, ethylene glycol monomethyl ether, ethylene glycol monoethyl ether, ethylene glycol monopropyl ether, and ethylene glycol monobutyl ether.

Of glycol ethers represented by the general formula (1), glycol ether preferably has n of 1 to 2. When one of R₁ and R₂ represents hydrogen, the other preferably represents an alkyl group having 1 to 4 carbon atoms, and when R₁ and R₂ each represent an alkyl group, R₁ and R₂ each preferably represent an alkyl group having 1 to 4 carbon atoms. n of 3 or more may cause degradation in compatibility with rubber. An alkyl group having 5 or more carbon atoms tends to degrade permeability to contamination on the surface of the mold (cavity surface).

The glycol ethers may be used as they are or by mixing with water, alcohols such as methanol, ethanol, and n-propanol, or an organic solvent such as toluene or xylene. In the case where the glycol ethers are mixed with an organic solvent, an amount of the organic solvent is generally 50 parts by weight (hereinafter, abbreviated as "parts") or less, and most generally 20 parts or less with respect to 100 parts of the glycol ethers. A conventionally used releasing agent may be used in an appropriate amount as required. In the case where the releasing agent is used, its use amount is 10 parts or less, and most generally 2 to 5 parts with respect to 100 parts of the unvulcanized rubber material and glycol ethers in total.

The unvulcanized rubber contains as a main component a single substance or a mixture of natural rubber (NR), chloroprene rubber (CR), butadiene rubber (BR), nitrile rubber (NBR), ethylene propylene diene rubber (EPDM), ethylene propylene rubber (EPM), styrene butadiene rubber (SBR), polyisoprene rubber (IR), butyl rubber (IIR), silicone rubber (Q), fluorine rubber (FKM), or the like. Further, the unvulcanized rubber contains a vulcanizing agent mixed, and a vulcanization accelerator, a reinforcing agent, and the like as required. The unvulcanized rubber is vulcanized in the mold and converts into vulcanized rubber. Preferred examples of the unvulcanized rubber include EPDM, EPM, SBR, NBR, BR, and a mixture thereof.

EPDM is a copolymer formed of a cyclic or non-cyclic monomer having ethylene, an α-olefin excluding ethylene, and a disconjugate double bond. To be more specific, EPDM is a terpolymer formed of ethylene, an α-olefin (inparticular, propylene) excluding ethylene, and a polyene monomer described below. Examples of the polyene monomer include: dicyclopentadiene; 1,5-cyclooctadiene; 1,4-cyclooctadiene; 1,6-cyclododecadiene; 1,7-cyclododecadiene; 1,5,9-cyclododecatriene; 1,4-cycloheptadiene; 1,4-cyclohexadiene; norbornadiene; methylene norbornene; ethylidene norbornene; 2-methyl pentadiene-1,4; 1,5-hexadiene; 1,6-heptadiene; methyl-tetrahydroindene; and 1,4-hexadiene. As copolymerization ratio of monomers, a terpolymer preferably contains 30 to 80 mol% of ethylene, 0.1 to 20 mol% of polyene, and the balance of α-olefin. A terpolymer more preferably contains 30 to 60 mol% of ethylene. Further, aterpolymerpreferablyhas a Mooney viscosity ML₁₊₄ (100°C) of 20 to 70.

SBR preferably has a styrene content of 15 to 30 mol% and a Mooney viscosity ML₁₊₄ (100°C) of 20 to 80, and preferably 35 to 60.

NBR preferably has an acrylonitrile content of 20 to 60 mol%, and preferably 25 to 45.mol%, and a Mooney viscosity ML₁₊₄ (100°C) of 20 to 85, and preferably 30 to 70.

BR preferably employs 1,2-polybutadiene or 1,4-polybutadiene alone or as a mixture and preferably has a Mooney viscosity ML₁₊₄ (100°C) of 20 to 85, and preferably 30 to 60.

The glycol ethers are mixed with the unvulcanized rubber and converted into an unvulcanized rubber material. In this case, the glycol ethers are generally mixed in an amount of 10 to 60 parts, and preferably about 15 to 25 parts with respect to 100 parts of the unvulcanized rubber. The glycol ethers preferably have a boiling point of about 130 to 250°C. That is, molding is generally conducted at 150 to 185°C. In the case where the boiling point of the glycol ethers is lower than 130°C, evaporation during cleaning is significant and thus a cleaning operating environment may degrade. In contrast, in the case where the boiling point thereof is higher than 250°C, evaporation involves difficulties and the glycol ethers remain in the vulcanized rubber. Thus, the vulcanized rubber may break or the like during taking out from the mold due to reduced strength, and contamination cannot sufficiently be peeled off from the surface of the mold, to thereby degrade cleaning operability.

Note that the mold cleaning material 2 containing as a mother material the unvulcanized rubber material may contain as a reinforcing agent an inorganic reinforcing agent (filler) such as silica, alumina, calcium carbonate, aluminum hydroxide, or titanium oxide. In this case, a use amount of the reinforcing agent is preferably set to 10 to 50 parts with respect to 100 parts of the unvulcanized rubber. As described above, a releasing agent may be mixed. Examples of the releasing agent include stearic acid, zinc stearate, carnauba wax, montan wax, and stearyl ethylene diamide. The releasing agent may be mixed in an amount of 1 to 10 parts with respect to 100 parts of the unvulcanized rubber.

Next, a second example of the item (A), that is, themoldcleaning material 2 for removing contamination will be described. The second example includes as amothermaterial an unvulcanized rubber material formed of a mixture of unvulcanized rubber and at least one of imidazoles and imidazolines (imidazoles and/or imidazolines). In the second example, a part different from the first example will be described mainly.

Favorable results can be obtained by using imidazoles represented by the following general formula (2). Typical examples of such imidazoles include: 2-methylimidazole; 2-ethyl-4-methylimidazole; 2-phenylimidazole; 1-benzyl-2-methylimidazole; 2,4-diamino-6-[2'-methylimidazolyl-(1')]ethyl-s-triazine; and 2,4-diamino-6[2'-ethyl-4'-methylimidazolyl-(1')]ethyl-s-triazine. 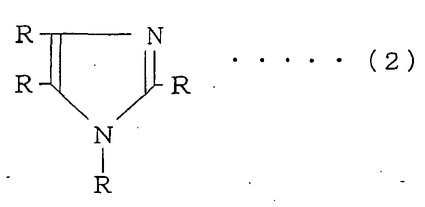 In the formula (2) : R represents H or a substituted or unsubstituted straight-chain hydrocarbon group having less than 11 carbon atoms; and Rs may be identical to or different from each other.

Favorable results can be obtained by using imidazolines represented by the following general formula (3) . Typical examples of such imidazolines include: 2-methylimidazoline; 2-methyl-4-ethylimidazoline; 2-phenylimidazoline; 1-benzyl-2-methylimidazoline; 2-phenyl-4-methyl-5-hydroxymethylimidazoline; 2,4-diamino-6[2'-methylimidazolinyl-(1')]ethyl-s-triazine; 2,4-diamino-6[2'-methyl-4'-ethylimidazolinyl-(1')]ethyl-s-triazine; 1-cyanoethyl-2-methylimidazoline; and 1-cyanoethyl-2-methyl-4-ethylimidazoline. 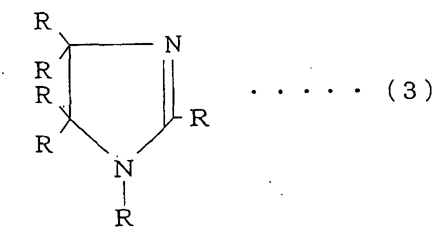 In the formula (3): R represents H or a substituted or unsubstituted straight-chain hydrocarbon group having less than 11 carbon atoms; and Rs may be identical to or different from each other.

Next, a third example of the item (A), that is, the mold cleaning material 2 for removing contamination will be described. The third example includes as a mother material an unvulcanized rubber material formed of a mixture of unvulcanized rubber and aminoalcohols. In the third example, a part different from the first example will be described mainly.

Favorable results can be obtained by using the following aminoalcohols. That is, examples of the aminoalcohols include: monoethanolamine; diethanolamine; triethanolamine; N-methylethanolamine; N,N-dimethylethanolamine; N,N-dibutylethanolamine; N,N-diethylethanolamine; N-methyl-N,N-diethanolamine; 2-amino-2-methylpropanol; 3-aminopropanol; and 2-aminopropanol.

Next, the item (B), that is, the mold cleaning material 2 for imparting releasability will be described. In this case, an unvulcanized rubber material formed of a mixture of unvulcanized rubber and.a releasing agent is used as a mother material. A part different from the first example will be described mainly.

Examples of the releasing agent include: a long-chain fatty acid such as stearic acid or behenic acid; a metal salt of a long-chain fatty acid such as zinc stearate or calcium stearate; ester-based wax such as carnauba wax, montan wax, or a partially saponified ester of montanic acid; a long-chain fatty acid amide such as stearyl ethylenediamide; and paraffins such as polyethylene wax.

The mold cleaning material 2 can be obtained by mixing the unvulcanized rubber and the releasing agent by a known method, for example, by using a calender roll or the like, and can be obtained by a method involving forming an uncalvanized rubber material in advance, mixing the releasing agent, and the like. In this case, the releasing agent is mixed in an amount of generally 1 to 50 parts, and preferably 3 to 20 parts with respect to 100 parts of the unvulcanized rubber material. The releasing agent preferably has a melting point of 200°C or lower and a boiling point of 200°C or higher, and more preferably a melting point of 50 to 150°C. That is, molding is generally conducted at 150 to 200°C. In the case where the melting point of the releasing agent is higher than 200°C, the releasing agent does not effuse to the surface of the mold. In the case where the boiling point thereof is lower than 200°C, the releasing agent may effuse to the surface of the mold but evaporates, and its function cannot be carried out.

A method of producing the sheet for regenerating a mold involves using the substrate sheet 1 and the mold cleaning material 2 and is conducted as follows, for example. That is, the mold cleaning material 2 is kneaded with a continuous kneader or a batch kneader, and is arranged on both sides of the substrate sheet 1. Then, the whole is sandwiched and pressed between two molds each having a concave part corresponding to a belt-like pattern of the mold cleaning material2. The resultant is rolled or cut into arbitrary dimensions. In this way, the sheet for regenerating a mold can be produced.

Note that in a gap part between the adjacent mold cleaning materials 2, the substrate sheet 1 may be exposed, or the gap part may be covered with the mold cleaning material 2. In the case where the gap part is covered, a thickness of the covering is preferably 20% or less of a thickness of the projected lines.

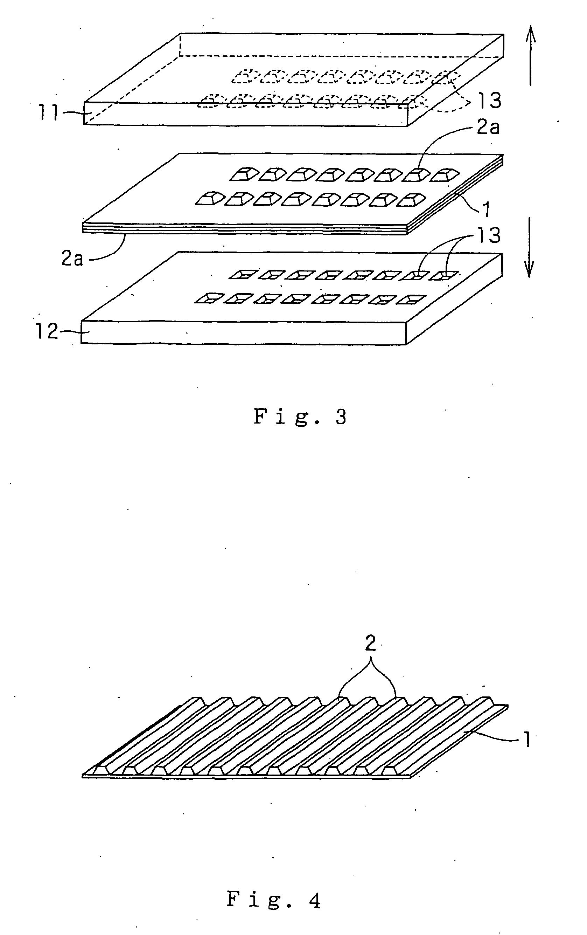

A method of cleaning the surface of the mold (cavity surface) by using such a sheet for regenerating a mold can be conducted as follows, for example. That is, as shown in FIG. 2, the sheet for regenerating a mold is sandwiched between an upper mold 11 and a lower mold 12. In this way, a part of an opening of a cavity 13 is blocked by the projected lines (mold cleaning material 2), and other parts of the opening is not blocked by the projected lines (mold cleaning material 2) and remain opened. Then, mold clamping is conducted in this state. In this way, the mold cleaning material 2 of the sheet for regenerating a mold is pressed against the surfaces of the upper mold 11 and the lower mold 12 and is filled into the cavity 13. At this time, air in the cavity 13 is discharged from the other parts of the opening of the cavity 13 not blocked by the mold cleaning material 2 while the mold cleaning material 2 is filled into the cavity 13, and the mold cleaning material 2 is filled throughout the cavity 13. That is, a gap between the adjacent (opposing) mold cleaning materials 2 serves as an air vent gap. Next, heat molding is conducted in this state. In this way, the mold cleaning material 2 containing as a main component an unvulcanized rubber-based composition is heated and vulcanized into vulcanized rubber and is molded into a shape of the cavity 13. At this time, contamination in the cavity 13 integrates with vulcanized rubber 2a (see FIG. 3). Then, as shown in FIG. 3, the upper mold 11 and the lower mold 12 are removed, and the sheet for regenerating a mold is released. At this time, the contamination on the surface (surface of the cavity 13) of each of the upper mold 11 and the lower mold 12 is transferred to and integrated with the vulcanized rubber 2a and is removed. In this way, the cleaning is conducted.

In the case where releasability is imparted to the surface (surface of the cavity 13) of each of the upper mold 11 and the lower mold 12, the same procedure is repeated. During heating and vulcanizing, the releasing agent in the mold cleaning material 2 effuses and imparts releasability throughout the cavity 13 (attaches the releasing agent).

FIG. 4 shows a second embodiment of the sheet for regenerating a mold which does not form part of the present invention. In the sheet for regenerating a mold according to this embodiment, the belt-like mold cleaning material 2 is formed on one side of the substrate sheet 1. Other parts are similar to those of the sheet for regenerating a mold according to the first embodiment shown in FIG. 1, and the same parts are represented by the same reference numerals.

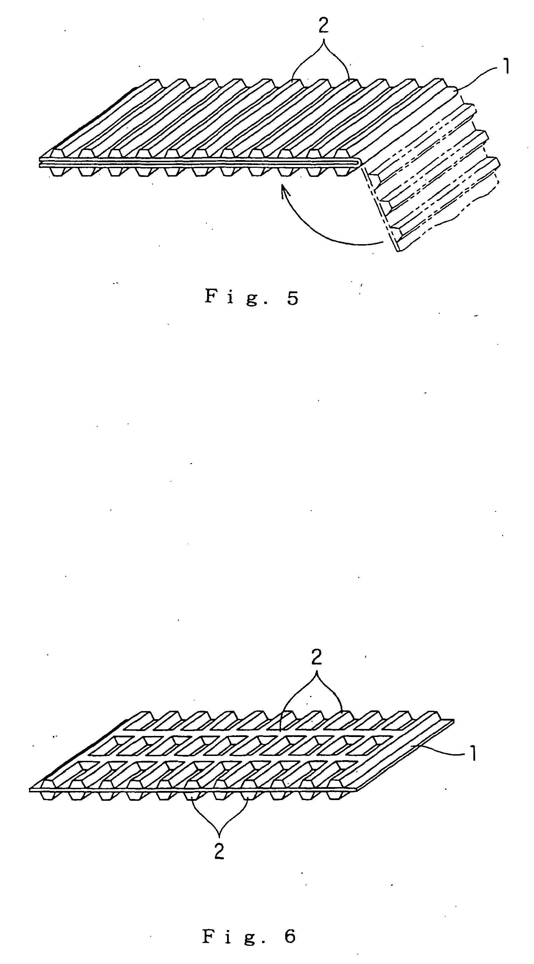

In the case where the sheet for regenerating a mold according to the second embodiment is used, as shown in FIG. 5, the sheet for generating a mold is folded such that the substrate sheet 1 is arranged inside and divided sections of the substrate sheet 1 obtained by thus being folded oppose each other. In this way, the sheet for regenerating a mold according to the second embodiment provides similar actions and effects as those of the sheet for regenerating a mold according to the first embodiment.

FIG. 6 shows a third embodiment of the sheet for regenerating a mold which does not form part of the present invention. In the sheet for regenerating a mold of this embodiment, projected lines in the sheet for regenerating a mold according to the first embodiment shown in FIG. 1 are formed vertically and horizontally on both sides of the substrate sheet 1. In this way, the mold cleaning material 2 is formed into a lattice pattern. Other parts are similar to those of the sheet for regenerating a mold according to the first embodiment shown in FIG. 1, and the same parts are represented by the same reference numerals. The sheet for regenerating a mold according to the third embodiment provides similar actions and effects as those of the sheet for regenerating a mold according to the first embodiment. Note that in the third embodiment, for favorable air vent property, a substrate sheet having air permeability is preferably used, and projected lines formed vertically and horizontally preferably have different heights.

Note that in the first to third embodiments, the projected lines each have a trapezoidal sectional shape. However, the sectional shape is not limited thereto, and may be rectangular, triangular, polygonal, semicircular, or the like. Of those, from a viewpoint of cleaning throughout the cavity 13 even in the case where the opening of the cavity 13 is small, a top part of each of the projected lines is preferably formed non-flat.

In the case where the top part of each of the projected lines is formed non-flat, filling of the mold cleaning material 2 may be started without blocking the entire opening of the small cavity 13. Thus, by applying such a sheet for regenerating a mold for cleaning of the small cavity 13, excellent filling property can be obtained. From a viewpoint of further improving filling property of the mold cleaning material 2, a curvature radius (curvature radius of a section perpendicular to a longitudinal direction of the belt-like pattern) of the top part is preferably within a range of 0.2 to 3.0 mm. Formation of a non-flat top part allows a wider base part and assures an amount (volume) of the mold cleaning material 2. Thus, even if the cavity 13 having a large volume is present in the mold, the amount of the mold cleaning material 2 is not insufficient during cleaning, and insufficient filling of the cavity 13 can be prevented.

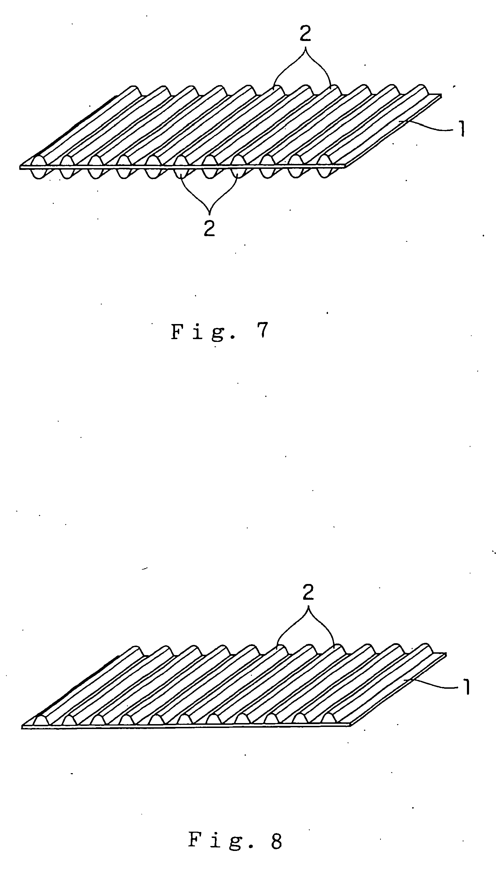

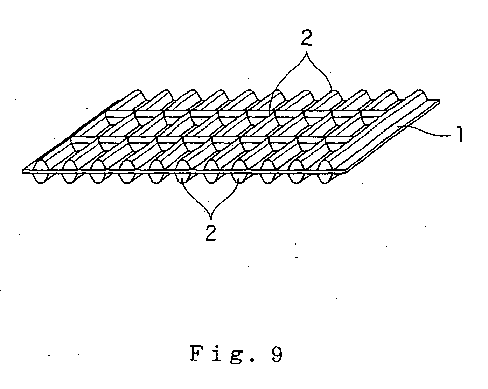

For example, the non-flat top part may be obtained by forming on a flat surface of a projected line one row or a plurality of rows of separate projected lines in a longitudinal direction of the lower projected line, obliquely at an angle, or laterally at an angle of 90°. As another example, the non-flat top part of the projected line may be obtained by forming dotted projected parts on the flat surface of the lower projected line. As still other examples, the top part of the projected line of the first embodiment (see FIG. 1) may be formed into a dome-shape (non-flat shape) to form a non-flat top part shown in FIG. 7, and the top part of the projected line of the second embodiment (see FIG. 4) may be formed into a dome-shape to forma non-flat top part shown in FIG. 8. Further, the top part of the projected line of the third embodiment (see FIG. 6) may be formed into a dome-shape to form a non-flat top part shown in FIG. 9.

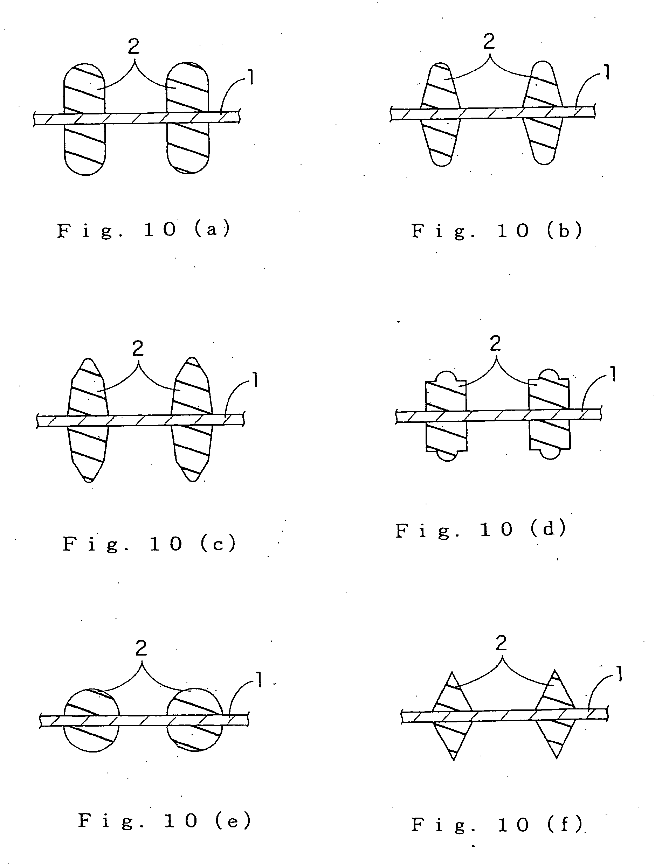

Other examples of the non-flat top part of the projected line include: a non-flat top part shown in FIG. 10(a) and obtained by forming a top part into a dome-shape and forming a lower part to have a rectangular section; a non-flat top part shown in FIG. 10 (b) and formed to have a substantially triangular section with a curved top part; a non-flat top part shown in FIG. 10(c) and formed to have a substantially pentagonal section with a curved top part; a non-flat top parts shown in FIG. 10(d) and obtained by forming the dome-shape of FIG. 10(a) with a small width; a non-flat top part shown in FIG. 10 (e) and formed to have a semicircular section; and a non-flat top part shown in FIG. 10(f) and formed to have a triangular section (with sharp top).

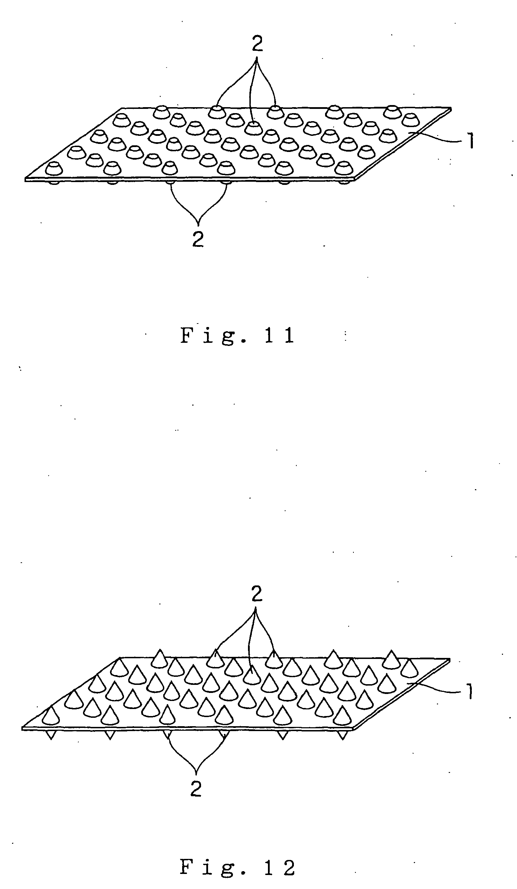

FIG. 11 shows a fourth embodiment of the sheet for regenerating a mold which does not form part of the present invention. In the sheet for regenerating a mold according to this embodiment, a plurality of truncated cones (dots) formed of the mold cleaning material 2 are present on both sides of the substrate sheet 1. In this way, the mold cleaning material 2 is formed into a dotted pattern. Other parts are similar to those of the sheet for regenerating a mold according to the first embodiment shown in FIG. 1, and the same parts are represented by the same reference numerals.

In the fourth embodiment, the shape of each of the dots (mold cleaning material 2) is a truncated cone. However, the shape thereof is not particularly limited, and examples of the shape include a cone, a pyramid, a column, a rectangular column, a cylinder, and a rectangular cylinder. Of those, from a viewpoint of cleaning throughout the cavity 13 even if the opening of the cavity 13 is small, a top part of each of the dots is preferably formed non-flat, similar to those shown in FIGS. 7 to 10. For example, the shape of each of the dots may be: a cone as shown in FIG. 12; a pyramid (not shown); a cone or pyramid having a curved top (not shown); or a truncated cone, column, rectangular column, cylinder, rectangular cylinder, or the like (not shown) having a non-flat top (inclined surface, uneven shape, or the like).

Next, dimensions of the mold cleaning material of the present invention will be described. The width of the projected pattern refers to a value at a base part of the projected pattern. For example, the width of the belt-like or lattice projected pattern refers to a value in a direction perpendicular to the longitudinal direction. The width of the dotted projected pattern refers to a small diameter of a base part of a circle or oval or a length of a shorter side of a base part of a rectangular shape. In other cases, the width refers to a minimum diameter of a three-point inscribed circle. The distance between the adjacent projected patterns refers to a distance between a base part of a wall surface of one of the projected patterns and a base part of a wall surface of the adjacent projected pattern, the wall surfaces opposing each other. In the case where the pattern has a round base part (having a fret shape), the width and distance refer to values obtained by using a point at which an extended line of a straight line part of a sectional wall of the projected pattern intersects a plane having the projected pattern formed thereon as a measurement point. In the case where the mold cleaning material having a certain thickness is formed on the substrate sheet and the projected pattern is formed thereon, the width and distance refer to the width and distance of the projected pattern on the surface of the mold cleaning material having a certain thickness and not the width and distance of the surface of the substrate sheet. In the case where the mold cleaning material having a certain thickness is not formed, the width and distance refer to the width and distance of the projected pattern on the surface of the substrate sheet. The width and distance are set in accordance with the dimensions of the mold forming the projected pattern, and may be confirmed by measuring the produced sheet for regenerating a mold by using a laser length measuring machine or the like.

The thickness of the projected pattern refers to a length of a perpendicular line from the top part of the projected pattern to the surface (in the case where the mold cleaning material having a constant thickness is formed on the substrate sheet, the surface of the mold cleaning material having a certain thickness, and in the case where the mold cleaning material having a constant thickness is not formed, the surface of the substrate sheet) of the base part of the projected pattern. The thickness is set in accordance with the dimensions of the mold forming the projected pattern, and may be confirmed by measuring the produced sheet for regenerating a mold by using a thickness measuring device such as a dial gauge.

The curvature radius of the top part is set in accordance with the dimensions of the mold forming the projected pattern, and may be confirmed by measuring the produced sheet for regenerating a mold by using non-contact three-dimensional measuring device.

Next, examples and comparative examples will be described. However, the present invention is not limited to the examples.

### Examples

### (Paper sheet)

Japanese paper (thin paper) was prepared as a substrate sheet. The Japanese paper had a thickness of 0.15 mm and a basis weight of 40 g/m².

### (Cloth sheet)

A spunbond nonwoven fabric formed of a polyester long fiber (Eltas E01070, available from Asahi Kasei Corporation) was prepared as a substrate sheet. The nonwoven fabric had a tear strength of 8.5 N, a thickness of 0.35 mm, and a basis weight of 70 g/m².

### (Plastic sheet)

A perforated sheet, a non-perforated sheet, and a porous sheet were prepared as substrate sheets. Of those, a polyethylene terephthalate film, a polyimide film, a polyethylene naphthalate film, a nylon 6 film, and a polypropylene film were prepared as the perforated sheets. A polyethylene terephthalate film and a nylon 12 film were prepared as the non-perforated sheets. A polypropylene porous sheet (available from Nitto Denko Corporation) was prepared as the porous sheet. The perforation treatment involved forming circular pores each having a diameter of 1 mm vertically and horizontally at a pitch of 2 mm. The substrate sheets each had a thickness of 50 µm.

### (Mold cleaning material)

100 parts of ethylene propylene rubber, 50 parts of silica powder, 5 parts of titanium oxide, 2 parts of an organic peroxide [n-butyl-4,4-bis(t-butylperoxy)valerate], 10 parts of imidazole(2,4-diamino-6-[2'-methylimidazolyl-(1')]ethyl-s-triazine}, and 5 parts of montan wax were kneaded with a kneader, to thereby prepare a mold cleaning material.

### (Examples 1 to 7)

The mold cleaning material was applied to both sides of the substrate sheet (Japanese paper, nonwoven fabric) so as to project into a pattern (belt-like, lattice, or dotted) and dimensions (width, thickness, and gap) shown in Table 1 described below.

### (Examples 8 to 15)

The mold cleaning material was applied to both sides of the substrate sheet (plastic sheet) so as to project into a pattern (belt-like, lattice, or dotted) and dimensions (width, thickness, and gap) shown in Table 2 described below.

### (Examples 16 to 21)

The mold cleaning material was formed into a belt-like pattern (see FIG. 7) having each sectional shape (see FIGS. 10(a) to 10(e)) and dimensions (width, thickness, curvature radius of top part, and gap) as shown in Table 3 described below on both sides of the substrate sheet. Note that the curvature radius of a top part refers to a curvature radius of a section perpendicular to a longitudinal direction of the belt-like pattern.

### (Comparative Examples 1 and 2)

The mold cleaning material was formed into a uniform flat pattern (a sheet having a uniform thickness) on both sides of the substrate sheet (Japanese paper, nonwoven fabric) (see Table 4 described below).

### (Comparative Examples 3 to 5)

The mold cleaning material was formed into a uniform flat pattern (a sheet having a uniform thickness) on both sides of the substrate sheet (plastic sheet) (see Table 4 described below).

### (Comparative Example 6)

The mold cleaning material was formed into a uniform flat pattern (a sheet having a uniform thickness) on both sides of the substrate sheet (nonwoven fabric) (see Table 4 described below).

### (Filling factor, filling property: Examples 1 to 15, Comparative Examples 1 to 5)

Cleaning of a mold was conducted by using the thus-obtained sheet for regenerating a mold of each of Examples 1 to 15 and Comparative Examples 1 to 5. This mold was a mold for transfer molding used for resin molding of a semiconductor device, and was formed of an upper mold and a lower mold each having a rectangular surface (opposing surface) of 24 mm × 91 mm. A shape of each cavity under mold clamping was a rectangular parallelepiped having dimensions of 4 mm × 5mm × 2 mm (height). Sixteen cavities were formed, and two rows of eight cavities were arranged parallel to each other. A distance between the two rows was 10 mm, and a distance between adjacent cavities in each row was 1 mm. Evaluation on filling factor was performed by evaluating a filling factor of a cavity having the lowest filling property of the sixteen cavities. The filling factor was determined by a ratio of a base area of the cavity to a base area of vulcanized rubber heat molded into a cavity shape through cleaning. A sheet for regenerating a mold having a filling factor of 100% was represented by o, and a sheet for regenerating a mold having a filling factor of less than 100% was represented by x. Tables 1, 2, and 4 show the results. Note that cleaning conditions included: dimensions of the sheet for regenerating a mold adjusted to the same dimensions as those of the mold surface; a mold clamping gap of the mold of 0.5 mm; a molding temperature of 175°C; and a molding time of 5 min.

### (Filling factor, filling property: Examples 16 to 21, Comparative Example 6)

Cleaning of a mold was conducted by using the thus-obtained sheet for regenerating a mold of each of Examples 16 to 21 and Comparative Example 6. This mold was a mold for transfer molding used for resin molding of a semiconductor device, and was formed of an upper mold and a lower mold each having a rectangular surface (opposing surface) of 24 mm × 91 mm. A shape of each cavity under mold clamping was a rectangular parallelepiped having dimensions of 2 mm × 2 mm × 2 mm (height). Twenty cavities were formed, and two rows of ten cavities were arranged parallel to each other. A distance between the two rows was 10 mm, and a distance between adjacent cavities in each row was 2 mm. Evaluation on filling factor was performed by evaluating a filling factor of a cavity having the lowest filling property of the twenty cavities. The filling factor was determined by a ratio of a base area of the cavity to a base area of vulcanized rubber heat molded into a cavity shape through cleaning. A sheet for regenerating a mold having a filling factor of 100% was represented by o, and a sheet for regenerating a mold having a filling factor of less than 100% was represented by x. Tables 3 and 4 show the results. Note that cleaning conditions included: dimensions of the sheet for regenerating a mold adjusted to the same dimensions as those of the mold surface; a mold clamping gap of the mold of 0.5 mm; a molding temperature of 175°C; and a molding time of 5 min.

### (Cleaning property: Examples 1 to 15 and Comparative Examples 1 to 5)

The sheet for regenerating a mold having a filling factor of 100% allowed cleaning throughout the cavity and was represented by o. The sheet for regenerating a mold having a filling factor of less than 100% involved insufficient of the cavity and was represented by ×. Tables 1, 2, and 4 show the results.

### (Cleaning property: Examples 16 to 21 and Comparative Examples 6)

The sheet for regenerating a mold having a filling factor of 100% allowed cleaning throughout the cavity and was represented by o. The sheet for regenerating a mold having a filling factor of less than 100% involved insufficient of the cavity and was represented by ×. Tables 3 and 4 show the results.

**[Table 1]**

| | | Examples | | | | | | |
|---|---|---|---|---|---|---|---|---|
| | | 1 | 2 | 3 | 4 | 5 | 6 | 7 |
| Substrate sheet | | Paper | Nonwoven fabric | | | | | |
| Mold cleaning material | Pattern | Belt-like | | | | | Lattice | Dotted |
| | Width (mm) | 2.5 | 1.0 | 3.0 | 5.0 | 7.0 | 2.0 | 1.0 |
| | Thickness (mm) | 2.0 | 1.0 | 3.0 | 5.0 | 7.0 | 2.0 | 1.0 |
| | Gap (mm) | 2.0 | 1.0 | 3.0 | 5.0 | 7.0 | 2.0 | 1.0 |
| Filling factor (%) | | 100 | 100 | 100 | 100 | 100 | 100 | 100 |
| Filling property | | ○ | ○ | ○ | ○ | ○ | ○ | ○ |
| Cleaning property | | ○ | ○ | ○ | ○ | ○ | ○ | ○ |

**[Table 2]**

| | | Examples | | | | | | | |
|---|---|---|---|---|---|---|---|---|---|
| | | 8 | 9 | 10 | 11 | 12 | 13 | 14 | 15 |
| Substrate sheet (*) | | (1) | (2) | (3) | (4) | (5) | (6) | (7) | (8) |
| Mold cleaning material | Pattern | Belt-like | | | Dotted | Lattice | Belt-like | | |
| | Width (mm) | 1.0 | 3.0 | 5.0 | 1.0 | 2.5 | 7.0 | 2.5 | 1.0 |
| | Thickness (mm) | 1.0 | 3.0 | 5.0 | 1.0 | 2.0 | 7.0 | 2.0 | 1.0 |
| | Gap (mm) | 1.0 | 3.0 | 5.0 | 1.0 | 2.0 | 7.0 | 2.0 | 2.0 |
| Filling factor (%) | | 100 | 100 | 100 | 100 | 100 | 100 | 100 | 100 |
| Filling property | | ○ | ○ | ○ | ○ | ○ | ○ | ○ | ○ |
| Cleaning property | | ○ | ○ | ○ | ○ | ○ | ○ | ○ | ○ |

**[Table 3]**

| | | Examples | | | | | |
|---|---|---|---|---|---|---|---|
| | | 16 | 17 | 18 | 19 | 20 | 21 |
| Substrate sheet | | Nonwoven fabric | | | | | |
| Mold cleaning material | Sectional shape of pattern (FIG. 8) | (a) | (b) | (c) | (d) | (a) | (e) |
| | Width of base (mm) | 3.0 | 3.0 | 3.0 | 4.0 | 3.0 | 4.0 |
| | Thickness (mm) | 3.0 | 3.0 | 3.0 | 4.0 | 3.0 | 4.0 |
| | Curvature radius of top part (mm) | 1.5 | 1.5 | 0.2 | 1.0 | 5.0 | - |
| | Gap (mm) | 3.0 | 3.0 | 3.0 | 4.0 | 3.0 | 4.0 |
| Filling factor (%) | | 100 | 100 | 100 | 100 | 100 | 100 |
| Filling property | | ○ | ○ | ○ | ○ | ○ | ○ |
| Cleaning property | | ○ | ○ | ○ | ○ | ○ | ○ |

**[Table 4]**

| | | Examples | | | | | |
|---|---|---|---|---|---|---|---|
| | | 1 | 2 | 3 | 4 | 5 | 6 |
| Substrate sheet (*) | | Paper | Nonwoven fabric | (1) | (2) | (3) | Nonwoven fabric |
| Mold cleaning material | Pattern | Flat | | | | | |
| | Thickness (mm) | 1.0 | 5.0 | 1.0 | 3.0 | 5.0 | 3.0 |
| Filling factor (%) | | 72 | 78 | 72 | 75 | 78 | 40 |
| Filling property | | × | × | × | × | × | × |
| Cleaning property | | × | × | × | × | × | × |

(*) (1): Polyethylene terephthalate film (perforated)
(2): Polyimide film (perforated)
(3): Polyethylene naphthalate film (perforated)
(4): Nylon 6 film (perforated)
(5): Polypropylene film (perforated)
(6): Polyethylene terephthalate film (not perforated)
(7): Nylon 12 film (not perforated)
(8): Porous sheet
(*) (1): Polyethylene terephthalate film (perforated)
(2): Polyimide film (perforated)
(3): Polyethylene naphthalate film (perforated)

The results of Tables 1 to 4 reveal that the sheet for regenerating a mold of each of Examples 1 to 21 had excellent filling property and cleaning property compared with those of.the sheet for regenerating a mold of each of Comparative Examples 1 to 6.

In particular, the results of Tables 3 and 4 reveal that even if an opening of the cavity was small (2 mm × 2 mm), the sheet for regenerating a mold of each of Examples 16 to 21 had excellent filling property and cleaning property. The sheet for regenerating a mold of Comparative Example 6 including a mold cleaning material formed into a uniform flat shape had degraded filling property and cleaning property.

Note that in Examples 16 to 21 and Comparative Example 6, the nonwoven fabric was used as the substrate sheet for the sheet for regenerating a mold, but the results of same tendency were obtained when Japanese paper (thin paper: thickness of 0.15 mm, basis weight of 40 g/m²) was used.

## Claims

1. A sheet for regenerating a mold, comprising: a substrate sheet (1) formed of one of a paper sheet, a cloth sheet, and a plastic sheet; and a mold cleaning material (2) containing as a main component an unvulcanized rubber-based composition, **characterized in that** said mold cleaning material projects in a predetermined pattern having a non-flat top part with an air vent gap, and is formed on at least one side of the substrate sheet.

2. A sheet for regenerating a mold according to claim 1, wherein the pattern is formed as one of a plurality of belts, a lattice, and a plurality of dots.

3. A sheet for regenerating a mold according to claim 2, wherein: a width and a thickness of each of the belts, vertical lines of the lattice, horizontal lines thereof, and the dots are set within a range of 1 to 5 mm; and a distance between adjacent belts, vertical lines of the lattice, horizontal lines thereof, and dots is set within a range of 1 to 5 mm.

4. A sheet for regenerating a mold according to claim 1, wherein the non-flat top part of the pattern is formed of a convex part having a curvature radius within a range of 0.2 to 3.0 mm.

5. A sheet for regenerating a mold according to claim 1, wherein the cloth sheet comprises of a nonwoven fabric.

6. A sheet for regenerating a mold according to claim 5, wherein the nonwoven fabric comprises a spunbond nonwoven fabric.

7. A sheet for regenerating a mold according to claim 1, wherein the substrate sheet is subjected to an embossing treatment.

8. A sheet for regenerating a mold according to claim 1, wherein the plastic sheet comprises one of a perforated sheet and a porous sheet.

## Patentansprüche

1. Flächengebilde zum Regenerieren einer Form, aufweisend: ein Substrat-Flächengebilde (1), das aus einem Flächengebilde aus Papier, Tuch oder Kunststoff ausgebildet ist; und ein Formreinigungsmaterial (2), das als Hauptbestandteil eine nicht-vulkanisierte Zusammensetzung auf Kautschukbasis aufweist, **dadurch gekennzeichnet, dass** das Formreinigungsmaterial in einem vorgegebenen Muster mit einem unebenen oberen Teil, der einen Lüftungsspalt aufweist, vorsteht und auf mindestens einer Seite des Substrat-Flächengebildes ausgebildet ist.

2. Flächengebilde zum Regenerieren einer Form nach Anspruch 1, wobei das Muster als eine Vielzahl von Bändern, als Gitter oder als eine Vielzahl von Punkten ausgebildet ist.

3. Flächengebilde zum Regenerieren einer Form nach Anspruch 2, wobei: eine Breite und eine Dicke eines jeden der Bänder, einer jeden der vertikalen Gitterlinien, einer jeden der horizontalen Gitterlinien und eines jeden der Punkte innerhalb eines Bereichs von 1 bis 5 mm eingestellt ist; und ein Abstand zwischen benachbarten Bändern, vertikalen Gitterlinien, horizontalen Gitterlinien und Punkten in einem Bereich von 1 bis 5 mm eingestellt ist.

4. Flächengebilde zum Regenerieren einer Form nach Anspruch 1, wobei der unebene obere Teil des Musters aus einem konvexen Teil mit einem Krümmungsradius in einem Bereich von 0,2 bis 3,0 mm ausgebildet ist.

5. Flächengebilde zum Regenerieren einer Form nach Anspruch 1, wobei das Flächengebilde aus Tuch einen Faservliesstoff enthält.

6. Flächengebilde zum Regenerieren einer Form nach Anspruch 5, wobei der Faservliesstoff einen Spinnvliesstoff aufweist.

7. Flächengebilde zum Regenerieren einer Form nach Anspruch 1, wobei das Substrat-Flächengebilde einer Prägebehandlung unterzogen wurde.

8. Flächengebilde zum Regenerieren einer Form nach Anspruch 1, wobei das Flächengebilde aus Kunststoff ein perforiertes Flächengebilde oder ein poröses Flächengebilde aufweist.

## Revendications

1. Feuille pour régénérer un moule, comprenant : une feuille (1) faisant office de substrat constituée soit d'une feuille de papier, soit d'une feuille de tissu, ou encore d'une feuille en matière plastique ; et une matière de nettoyage de moule (2) contenant, à titre de composant principal, une composition à base de caoutchouc non vulcanisé, **caractérisée en ce que** ladite matière de nettoyage de moule fait saillie sous la forme d'un motif prédéterminé possédant une partie supérieure non plate comprenant un vide pour l'évacuation de l'air et est formée sur au moins un côté de la feuille faisant office de substrat.

2. Feuille pour régénérer un moule selon la revendication 1, dans laquelle le motif est constitué de plusieurs courroies, d'un réseau et de plusieurs points.

3. Feuille pour régénérer un moule selon la revendication 2, dans laquelle la largeur et l'épaisseur de chacune des courroies, des lignes verticales du réseau, des lignes horizontales de ce dernier, ainsi que des points sont réglées dans la plage de 15 mm ; et la distance séparant des courroies adjacentes, des lignes verticales adjacentes du réseau, des lignes horizontales adjacentes de ce dernier et des points adjacents est réglée dans la plage de 1 à 5 mm.

4. Feuille pour régénérer un moule selon la revendication 1, dans laquelle la partie supérieure non plate du motif est constituée d'une partie convexe possédant un rayon de courbure dans la plage de 0,2 à 3,0 mm.

5. Feuille pour régénérer un moule selon la revendication 1, dans laquelle la feuille en tissu comprend un tissu non-tissé.

6. Feuille pour régénérer un moule selon la revendication 5, dans laquelle le tissu non-tissé comprend un tissu non-tissé par filage direct.

7. Feuille pour régénérer un moule selon la revendication 1, dans laquelle la feuille faisant office de substrat est soumise à un traitement d'emboutissage.

8. Feuille pour régénérer un moule selon la revendication 1, dans laquelle la feuille en matière plastique comprend soit une feuille perforée, soit une feuille poreuse.
